# EUROPEAN PATENT APPLICATION

(11) **EP 4 557 378 A1**
(43) Date of publication of application: **21.05.2025**
(21) Application number: 23841875.0
(22) Date of filing: 16.05.2023
(51) Int. Cl.: H01L 31/02, H01L 31/05, H01L 31/049, H01L 31/18, H01L 31/048, H02S 30/10, H02S 40/34

(54) **PHOTOVOLTAIC CELL UNIT AND PREPARATION METHODS THEREFOR**

(30) Priority: 21.07.2022 CN 202210860115; 22.02.2023 CN 202310145937
(71) Applicant: Changzhou Shichuang Energy Co., Ltd, Changzhou, Jiangsu 213300 (CN)
(72) Inventor: WANG, Weiliang, Hangzhou, Jiangsu 213300 (CN); CHEN, Zhangyang, Pingxiang, Jiangxi 337000 (CN); CAO, Yuhong, Nanjing, Jiangsu 211100 (CN); FU, Liming, Hangzhou, Zhejiang 310000 (CN)
(74) Representative: Miller, Ronald Anthony
(86) International application number: PCT/CN2023/094484
(87) International publication number: WO 2024/016806

(57) **Abstract**

Provided is a photovoltaic cell unit, including conductive connection strips respectively arranged on two sides of a cell sheet and parallel to each other. A front surface and a back surface of the cell sheet are respectively connected to the conductive connection strips through a plurality of metal wires. Also provided are two methods for manufacturing a photovoltaic module. The present disclosure can reduce the consumption of silver on the surface of the cell sheet, alleviate the shading of light by the metal wires, and speed up the manufacturing of photovoltaic modules. According to the present disclosure, a plurality of cell sheets can be placed simultaneously during cell sheet placement, thereby increasing the cell sheet placement speed. The present disclosure can lower the requirements on the precision of cell sheet arrangement, the cell sheet placement process no longer requires visual and robot-based high-precision positioning, and effective placement of cell sheets can be achieved by simple mechanical positioning. The present disclosure is applicable to a stacked grid cell having a stacked grid structure. A photo-generated current of the stacked grid cell vertically flows from the inside of the cell sheet directly to the metal wires through an ultra-thin seed layer and is not transmitted transversely, so that a low loss caused by electrical resistance is achieved, the consumption of noble metal silver can be reduced, and the shading of light by silver grid lines can be avoided.

## Description

### TECHNICAL FIELD

The present disclosure relates to a photovoltaic cell unit and a use thereof.

### BACKGROUND

In the existing crystalline silicon photovoltaic industry chain, silicon wafers are used to make cell sheets. Metal patterns for collecting a current are prepared in advance on the surface of a cell sheet. The pattern for collecting the current in the cell sheet is a finger. Considering the shading of light and the transmission loss of the current, the aspect ratio of the finger should be as large as possible. The pattern for connecting the cell sheets in series and collecting the currents from the fingers is a busbar. To a certain extent, the greater the number of busbars, the fewer and thinner the silver fingers can be, such that the loss caused by the thermal resistance of the fingers is reduced. As such, the silver consumption of the cell sheet is reduced while the efficiency is improved. Therefore, the cell sheets have been developing toward more and more busbars. A larger number of busbars in a photovoltaic module indicates that more and thinner ribbons are required to connect the cell sheets, and also indicates a higher difficulty in module manufacturing and process control. At present, the series connection of multi-busbar cells on the market is mainly achieved using round wire or triangular ribbons, which not only provide a connection function in the circuit, but also have a surface light reflection that can be reused to improve the light utilization of the photovoltaic module. A multi-busbar cell generally includes 9 to 20 busbars. Compared with the number of fingers in the cell and the width of the cell sheet, the number of busbars and the actual light shading area of the ribbons are still relatively small, and have limited impact on the light utilization of the entire module. Therefore, there are no stringent and particular requirements on the ribbons, e.g., on the fillet radius of the vertex angle of the triangular ribbon or on the reflectivity of the ribbon surface.

Conventional photovoltaic modules have the following disadvantages.

The current path of the cell sheet is complex. A photo-generated current is collected from the cell substrate to the fingers, transmitted transversely to the busbars through the fingers, then transmitted longitudinally to the ribbons, and then transmitted out of the cell sheet through the ribbons.

The silver consumption for metalization of the cell sheet is too high.

The light shading area of metal on the surface of the cell sheet is large, affecting the efficiency of the cell and the module.

The current of the cell sheet is transmitted and collected through the metal fingers on the surface, and the loss caused by the thermal resistance during transmission reduces the output power of the cell and the module.

The manufacturing speed of photovoltaic modules is slow. For two adjacent cell sheets in the module, the front surface of one cell sheet is connected in series to the back surface of the other cell sheet through a ribbon. Such a connection mode makes it difficult to further significantly increase the module manufacturing speed after the module manufacturing speed has reached a certain level.

Light utilization at the gaps between cell sheets in conventional modules is low.

### SUMMARY

To solve the disadvantages in the prior art, the present disclosure provides a photovoltaic cell unit, including: a cell sheet, a first conductive connection strip, and a second conductive connection strip, where the first conductive connection strip and the second conductive connection strip are respectively arranged on two sides of the cell sheet. The first conductive connection strip is parallel to the second conductive connection strip.

A front surface of the cell sheet is connected to a bottom surface of the first conductive connection strip through a plurality of first metal wires parallel to each other. Each of the plurality of first metal wires is fixedly connected to the bottom surface of the first conductive connection strip through a first electrical connection material. Each of the plurality of first metal wires is further fixedly connected to the front surface of the cell sheet through a second electrical connection material. An end of each of the plurality of first metal wires distant from the first conductive connection strip does not extend to an outer side of the cell sheet;

A back surface of the cell sheet is connected to a top surface of the second conductive connection strip through a plurality of second metal wires parallel to each other. Each of the plurality of second metal wires is fixedly connected to the top surface of the second conductive connection strip through a third electrical connection material. Each of the plurality of second metal wires is further fixedly connected to the back surface of the cell sheet through a fourth electrical connection material. An end of each of the plurality of second metal wires distant from the second conductive connection strip does not extend to the outer side of the cell sheet.

Preferably, the first electrical connection material on the bottom surface of the first conductive connection strip and the third electrical connection material on the top surface of the second conductive connection strip can be melted and solidified again during module lamination.

For details of the photovoltaic cell unit of the present disclosure, see Example 1.

The present disclosure also provides two methods for manufacturing a photovoltaic module, both of which use the photovoltaic cell unit described above. For steps of the methods, see Example 2 and Example 3.

### Advantages

The present disclosure has the following advantages.

In the photovoltaic cell unit of the present disclosure, metal wires (including the first metal wires and the second metal wires) and conductive connection strips (including the first conductive connection strip and the second conductive connection strip) are integrated on the cell sheet. The resulting structure can be regarded as a cell unit as a whole. The whole process from the cell unit to the photovoltaic module is the manufacturing process of the photovoltaic module. Because all the metal wires (including the first metal wires and the second metal wires) for collecting and transmitting the current and all the conductive connection strips (including the first conductive connection strip and the second conductive connection strip) for connecting cell sheets have been connected in advance on the cell sheet, the module manufacturing process of the present disclosure is much simpler than conventional module manufacturing processes.

In the structure of the photovoltaic cell unit of the present disclosure, the current on the surface of the cell sheet (including the front surface and the back surface of the cell sheet) can be directly collected and transmitted through the metal wires (including the first metal wires and the second metal wires), so that a very large number of metal wires can be densely arranged on the surface of the cell. For example, the number of metal wires on the surface of a cell sheet with a width of 166 mm can exceed 120. Modules using such a structure cannot be encapsulated using conventional series soldering processes and encapsulating processes. The most significant difference between the module manufacturing method of the present disclosure and conventional module manufacturing methods is that the conventional series soldering step is not needed in the present disclosure. Conventional series soldering processes cannot meet requirements of series connection of such cells having a very large number of metal wires. In the present disclosure, first, metal wires (including the first metal wires and the second metal wires) and conductive connection strips (including the first conductive connection strip and the second conductive connection strip) are integrated on the cell sheet to form an independent photovoltaic cell unit, and then, the photovoltaic cell units are connected end to end. As such, the connection process can be simplified while realizing the series connection of cells having a very large number of metal wires. Moreover, according to the present disclosure, a plurality of cell sheets can be placed simultaneously during cell sheet placement, thereby increasing the cell sheet placement speed. In addition, the present disclosure can lower the requirements on the precision of cell sheet arrangement, the cell sheet placement process no longer requires visual and robot-based high-precision positioning, and effective placement of cell sheets can be achieved by simple mechanical positioning.

In the present disclosure, in terms of electrical connection between cell sheets, metal wires (including the first metal wires and the second metal wires) are sandwiched between a pair of conductive connection strips (including the first conductive connection strip and the second conductive connection strip), and then soldered at high temperature in a laminating machine. As such, an effective connection of the very large number of ultra-fine metal wires can be easily realized to ensure that the current between cell sheets can be effectively transmitted on each metal wire.

For a cell with a transparent conductive oxide (TCO) on its surface (such as a heterojunction with intrinsic thin layer (HJT) cell), metal wires (including the first metal wires and the second metal wires) may be directly electrically connected to the TCO through a conductive adhesive, an alloy, etc. For a cell without TCO on its surface, metal wires (including the first metal wires and the second metal wires) may be electrically connected to metal grid lines on the cell surface through a conductive adhesive, an alloy, etc. The above structure may be applied to most solar cells with a metal pattern on the surface or without a metal pattern on the surface while using TCO to collect the current, such as passivated emitter and rear cell (PERC), tunnel oxide passivated contact (TOPCon), and HJT cells.

The photo-generated current of the photovoltaic cell unit of the present disclosure is collected on the surface of the cell sheet (including the front surface and the back surface of the cell sheet) and transmitted to the metal wires (including the first metal wires and the second metal wires) without passing through the fingers. Because the electrical resistance of the metal wires (including the first metal wires and the second metal wires) is much lower than the electrical resistance of the fingers, the loss of the current transmitted in the metal wires (including the first metal wires and the second metal wires) caused by the thermal resistance can be significantly reduced. Once the loss is reduced, the output power of the module is improved.

The present disclosure can reduce the silver paste consumption of the photovoltaic module. Since the current on the surface of the cell sheet (including the front surface and the back surface of the cell sheet) is collected and transmitted through the metal wires (including the first metal wires and the second metal wires), the silver paste is only used to provide a function of connecting the metal wires and the cell sheets, and the current is transmitted in the silver paste only in the longitudinal direction perpendicular to the surface of the cell sheet, and is not transmitted in the transverse direction. Therefore, the need for a large amount of silver paste to reduce the transverse resistance is obviated, and the height of the silver paste can be reduced to 5 µm or less, thereby significantly reducing the consumption of silver paste. The present disclosure can significantly reduce the silver consumption of PERC, TOPCon, HJT, and other types of cells by a maximum of 80% or more.

In conventional cells, 3% to 5% of light received is shaded by the fingers and ribbons, resulting in a high loss due to the shading of light. In the present disclosure, the cross-section of each of the metal wires (including the first metal wires and the second metal wires) on the surface of the cell sheet is preferably in the shape of a highly reflective triangular structure, and direct light incident on the surfaces of the metal wires is finally reflected to the cell sheet and absorbed by the cell sheet. Therefore, the metal wires do not shade the incident light on the surface of the cell sheet, and the photovoltaic module has a high light receiving rate and therefore achieves a high efficiency.

In the present disclosure, the conductive connection strips (including the first conductive connection strip and the second conductive connection strip) for connecting cell sheets may have a highly reflective sawtooth structure to form secondary total internal reflection of the incident light, so that the light is finally reflected back to the cell sheet, thereby improving the utilization of light at the gaps between cell sheets. At present, there is no simple, effective, and easy-to-operate method available for utilizing incident light between cell sheets. The conductive connection strips (including the first conductive connection strip and the second conductive connection strip) designed in the present disclosure for connecting cell sheets can achieve effective utilization of the light at the gaps between cell sheets through simple operation.

Based on the above, the present disclosure can significantly reduce the consumption of silver on the surface of the cell sheet, alleviate the shading of light by metal wires, and significantly speed up the manufacturing of photovoltaic modules.

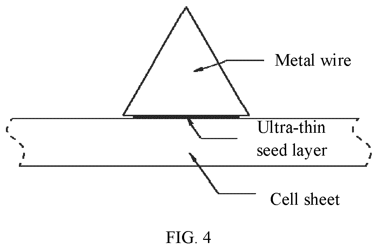

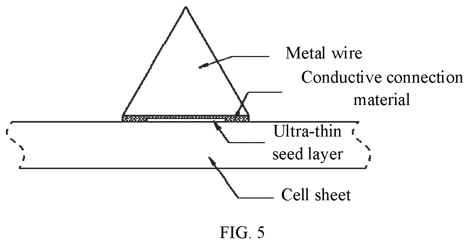

The solution of the present disclosure is applicable to a stacked grid cell having a stacked grid structure. As shown in FIG. 4, the stacked grid structure includes ultra-thin seed layers in a form of grid lines provided on surfaces of a cell sheet, and metal wires respectively stacked on the ultra-thin seed layers. The metal wires are respectively parallel to the ultra-thin seed layers on which the metal wires are respectively located, and a width of each of the metal wires is not less than a width of a respective one of the ultra-thin seed layers on which the metal wires are respectively located. Each of the ultra-thin seed layers has a thickness of less than or equal to 5 µm. Specifically, as shown in FIG. 5, each of the metal wires and the respective one of the ultra-thin seed layers on which the metal wires are respectively located are fixedly connected through a conductive connection material. Specifically, each of the metal wires and the respective one of the ultra-thin seed layers on which the metal wires are respectively located are fixedly connected through soldering, a conductive curing adhesive, a conductive adhesive tape, or other means.

The ultra-thin seed layers are mainly used for collecting and longitudinally conducting the photo-generated current in the cell substrate. The metal wires are mainly used for transmitting the photo-generated current out of the cell sheet.

Specifically, for the transmission path of the photo-generated current of the stacked grid cell, the photo-generated current is collected from the cell substrate to the ultra-thin seed layers in the form of grid lines, then longitudinally transmitted from the ultra-thin seed layers to the metal wires, and then transmitted out of the cell sheet through the metal wires. The current does not need to be transversely transmitted through the ultra-thin seed layers.

It can be seen that the stacked grid cell has a simple structure and a short current transmission path. The cell substrate, the ultra-thin seed layers, and the metal wires are stacked together in the vertical direction, and the photo-generated current vertically flows from the inside of the cell sheet directly to the metal wires through the ultra-thin seed layers and is not transmitted transversely, so that a low loss caused by electrical resistance is achieved, the consumption of noble metal silver for transverse transmission can be reduced, and the shading of light by silver grid lines can be avoided or alleviated.

### BRIEF DESCRIPTION OF THE DRAWINGS

FIG. 1 is a schematic top view of a photovoltaic cell unit according to the present disclosure.
FIG. 2 is a schematic side view of a photovoltaic cell unit according to the present disclosure.
FIG. 3 is a schematic view showing a stack of a photovoltaic module according to Example 2 and Example 3 of the present disclosure.
FIG. 4 and FIG. 5 are each a schematic view of a stacked grid structure.

### EMBODIMENTS OF THE PRESENT DISCLOSURE

### DETAILED DESCRIPTION OF THE EMBODIMENTS

The specific embodiments of the present disclosure will be described in further detail with reference to the accompanying drawings and examples. The following embodiments are merely used for more clearly describing the technical solutions of the present disclosure, and are not intended to limit the protection scope of the present disclosure.

The following technical solutions are employed in the embodiments of the present disclosure.

### Example 1

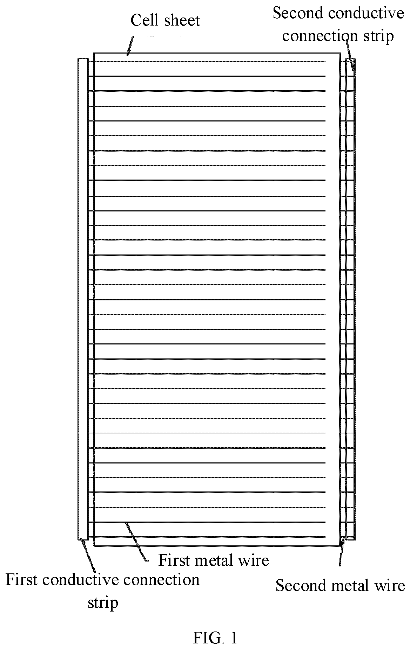

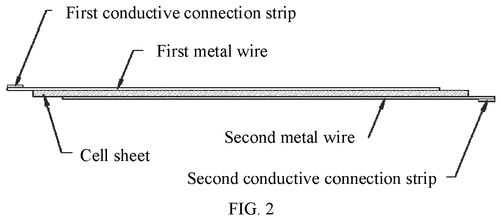

As shown in FIG. 1 and FIG. 2, the present disclosure provides a photovoltaic cell unit, which includes a rectangular cell sheet, a first conductive connection strip, and a second conductive connection strip, where the first conductive connection strip and the second conductive connection strip are respectively arranged on two sides of the cell sheet. The first conductive connection strip and the second conductive connection strip are parallel to a pair of edge lines of the cell sheet. The first conductive connection strip and the second conductive connection strip are symmetrically arranged. A pitch between the first conductive connection strip and the cell sheet and a pitch between the second conductive connection strip and the cell sheet are not greater than 5 mm (preferably range from 0.5 mm to 5 mm).

A front surface of the cell sheet is connected to a bottom surface of the first conductive connection strip through a plurality of first metal wires arranged parallel to each other and at intervals. The plurality of first metal wires are perpendicular to the first conductive connection strip. Each of the plurality of first metal wires has a line width of 0.05 mm to 0.2 mm. A pitch between two adjacent ones of the plurality of first metal wires ranges from 1 mm to 3 mm. Each of the plurality of first metal wires is fixedly connected to the bottom surface of the first conductive connection strip through a first electrical connection material. Each of the plurality of first metal wires is further fixedly connected to the front surface of the cell sheet through a second electrical connection material. An end of each of the plurality of first metal wires distant from the first conductive connection strip does not extend to an outer side of the cell sheet.

A back surface of the cell sheet is connected to a top surface of the second conductive connection strip through a plurality of second metal wires arranged parallel to each other and at intervals. The plurality of second metal wires are perpendicular to the second conductive connection strip. Each of the plurality of second metal wires has a line width of 0.05 mm to 0.2 mm. A pitch between two adjacent ones of the plurality of second metal wires ranges from 1 mm to 3 mm. Each of the plurality of second metal wires is fixedly connected to the top surface of the second conductive connection strip through a third electrical connection material. Each of the plurality of second metal wires is further fixedly connected to the back surface of the cell sheet through a fourth electrical connection material. An end of each of the plurality of second metal wires distant from the second conductive connection strip does not extend to the outer side of the cell sheet.

### Specifically,

each of the first electrical connection material, the second electrical connection material, the third electrical connection material, and the fourth electrical connection material may be a conductive adhesive (e.g., a colloidal material filled with conductive particles), a conductive paste (e.g., silver paste), a solder material (e.g., soldering tin or other alloy materials), or other conductive bonding materials.

The plurality of first metal wires and the plurality of second metal wires may each have a triangular cross-section, a circular cross-section, a semicircular cross-section, a trapezoidal cross-section, a rectangular cross-section, or the like. Preferably, the plurality of first metal wires and the plurality of second metal wires each have a cross-section in a shape of a triangle, where a fillet radius R of a vertex angle of the triangle is 0.03 mm or less, base angles of the triangle are greater than 45°, and a base width of the triangle ranges from 0.05 mm to 0.2 mm.

Surfaces of the plurality of first metal wires and the plurality of second metal wires may be highly reflective surfaces each with a reflectivity of 80% or more.

The first conductive connection strip and the second conductive connection strip may each have a triangular cross-section, a circular cross-section, a semicircular cross-section, a trapezoidal cross-section, a rectangular cross-section, a sawtooth-shaped cross-section, or the like. Preferably, a first reflective structure with a reflectivity of 80% or more is provided on the bottom surface of the first conductive connection strip connected to the plurality of first metal wires; a second reflective structure with a reflectivity of 80% or more is provided on the top surface of the second conductive connection strip connected to the plurality of second metal wires; and each of the first reflective structure and the second reflective structure may be a triangular sawtooth structure, where a vertex angle of a tooth of the triangular sawtooth structure ranges from 90° to 140°, and a fillet radius R of the vertex angle is less than or equal to 0.05 mm.

### Example 2

This example is the same as Example 1 except that in this example,
the front surface of the cell sheet is an insulating surface, ultra-thin seed layers are provided on the front surface of the cell sheet and configured to conduct a current, and the plurality of first metal wires are fixedly connected to the seed layers through a fifth electrical connection material, respectively; each of the seed layers preferably has a thickness of less than or equal to 5 µm; and the seed layers may be seed layers in a metallization electroplating process.

### Example 3

This example is the same as Example 1 except that in this example,
the cell sheet has a stacked grid structure. The stacked grid structure includes ultra-thin seed layers in a form of grid lines provided on surfaces of the cell sheet, and metal wires respectively stacked on the ultra-thin seed layers. The metal wires are respectively parallel to the ultra-thin seed layers on which the metal wires are respectively located. A width of each of the metal wires is not less than a width of a respective one of the ultra-thin seed layers on which the metal wires are respectively located. Each of the ultra-thin seed layers has a thickness of less than or equal to 5 µm. Each of the metal wires and the respective one of the ultra-thin seed layers on which the metal wires are respectively located are fixedly connected through a conductive connection material. Specifically, each of the metal wires and the respective one of the ultra-thin seed layers on which the metal wires are respectively located are fixedly connected through soldering, a conductive curing adhesive, a conductive adhesive tape, or other means.

More specifically,
the ultra-thin seed layers include: a plurality of first ultra-thin seed layers, where the plurality of first ultra-thin seed layers are provided on the front surface of the cell sheet and respectively correspond to the plurality of first metal wires; and a plurality of second ultra-thin seed layers, where the plurality of second ultra-thin seed layers are provided on the back surface of the cell sheet and respectively correspond to the plurality of second metal wires.

The plurality of first metal wires are respectively stacked on the plurality of first ultra-thin seed layers. The first metal wires are respectively parallel to the first ultra-thin seed layers on which the first metal wires are respectively located. A width of each of the first metal wires is not less than a width of a respective one of the first ultra-thin seed layers on which the first metal wires are respectively located. Each of the first ultra-thin seed layers has a thickness of less than or equal to 5 µm. Each of the first metal wires and a respective one of the first ultra-thin seed layers on which the first metal wires are respectively located are fixedly connected through a conductive connection material. Specifically, each of the first metal wires and a respective one of the first ultra-thin seed layers on which the first metal wires are respectively located are fixedly connected through soldering, a conductive curing adhesive, a conductive adhesive tape, or other means.

The plurality of second metal wires are respectively stacked on the plurality of second ultra-thin seed layers. The second metal wires are respectively parallel to the second ultra-thin seed layers on which the second metal wires are respectively located. A width of each of the second metal wires is not less than a width of a respective one of the second ultra-thin seed layers on which the second metal wires are respectively located. Each of the second ultra-thin seed layers has a thickness of less than or equal to 5 µm. Each of the second metal wires and a respective one of the second ultra-thin seed layers on which the second metal wires are respectively located are fixedly connected through a conductive connection material. Specifically, each of the second metal wires and a respective one of the second ultra-thin seed layers on which the second metal wires are respectively located are fixedly connected through soldering, a conductive curing adhesive, a conductive adhesive tape, or other means.

### Example 4

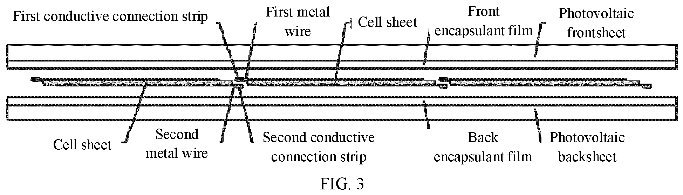

As shown in FIG. 3, the present disclosure also provides a method for manufacturing a photovoltaic module by using the photovoltaic cell unit of Example 1, Example 2, or Example 3. The first electrical connection material on the bottom surface of the first conductive connection strip and the third electrical connection material on the top surface of the second conductive connection strip can be melted and solidified again during module lamination. The method includes the following steps.
1) A photovoltaic frontsheet (e.g., photovoltaic glass) and a front encapsulant film are laid. The size of the front encapsulant film is substantially the same as that of the photovoltaic frontsheet. The front encapsulant film is laid flat on the photovoltaic frontsheet.
2) Photovoltaic cell units are grabbed using a robotic arm or a mechanical suction cup (where one or more photovoltaic cell units may be grabbed each time), and the photovoltaic cell units are laid flat on the front encapsulant film according to a module circuit connection structure to form one or more cell strings. In a cell string of the one or more cell strings, the first conductive connection strip of a photovoltaic cell unit of the photovoltaic cell units is stacked on the second conductive connection strip of an adjacent photovoltaic cell unit of the photovoltaic cell units. The plurality of first metal wires on the bottom surface of the first conductive connection strip and the plurality of second metal wires on the top surface of the second conductive connection strip are sandwiched between the first conductive connection strip and the second conductive connection strip to ensure an effective connection between two adjacent cell sheets in the cell string. Because the electrical connection on the surface of the cell sheet has been completed (i.e., the plurality of first metal wires have been fixedly connected to the front surface of the cell sheet, and the plurality of second metal wires have been fixedly connected to the back surface of the cell sheet), only the electrical connection between the photovoltaic cell units needs to be implemented in this step. Therefore, the requirements on the precision of grabbing and placing the cell sheets in this step are much lower, and multiple cell sheets can be grabbed at the same time, thereby increasing the cell sheet placement speed. The first conductive connection strip and the second conductive connection strip stacked together form a pair of conductive connection strips.
3) A bus wire and electrode lead wires are soldered. The one or more cell strings are connected through the bus wire to complete the entire circuit of the module. The electrode lead wires are soldered at wire lead-out positions to connect to an external junction box.
4) A back encapsulant film and a photovoltaic backsheet (which may be back glass) are laid, to form a stack to be laminated.
5) The stack is laminated in a laminating machine, so that the stack is squeezed and bonded into a unity. The lamination is performed at a temperature ranging from 130°C to 160°C. During the lamination, the first electrical connection material and the third electrical connection material between the pair of conductive connection strips are melted to fixedly connect the pair of conductive connection strips and the plurality of first metal wires and the plurality of second metal wires between the pair of conductive connection strips together, so as to realize a stable electrical connection between adjacent cell sheets.
6) The junction box and a module frame are installed, and the electrical connection materials are solidified.

### Example 5

As shown in FIG. 3, the present disclosure also provides another method for manufacturing a photovoltaic module by using the photovoltaic cell unit of Example 1, Example 2, or Example 3. The method includes the following steps.
1) A photovoltaic frontsheet (e.g., photovoltaic glass) and a front encapsulant film are laid. The size of the front encapsulant film is substantially the same as that of the photovoltaic frontsheet. The front encapsulant film is laid flat on the photovoltaic frontsheet.
2) Photovoltaic cell units are grabbed using a robotic arm or a mechanical suction cup (where one or more photovoltaic cell units may be grabbed each time), and the photovoltaic cell units are laid flat on the front encapsulant film according to a module circuit connection structure to form one or more cell strings. In a cell string of the one or more cell strings, the first conductive connection strip of a photovoltaic cell unit is stacked on the second conductive connection strip of a photovoltaic cell unit adjacent to the photovoltaic cell unit. The first metal wires on the bottom surface of the first conductive connection strip and the second metal wires on the top surface of the second conductive connection strip are sandwiched between the first conductive connection strip and the second conductive connection strip, to ensure an effective connection between adjacent cell sheets in the cell string. Because the electrical connection on the surface of the cell sheet has been completed (i.e., the first metal wires have been fixedly connected to the front surface of the cell sheet, and the second metal wires have been fixedly connected to the back surface of the cell sheet), only the electrical connection between the photovoltaic cell units needs to be implemented in this step. Therefore, the requirements on the precision of grabbing and placing the cell sheets in this step are much lower, and multiple cell sheets can be grabbed at the same time, thereby increasing the cell sheet placement speed. The first conductive connection strip and the second conductive connection strip stacked together form a pair of conductive connection strips.
3) The first electrical connection material and the third electrical connection material between the pair of conductive connection strips are heated, so that the first electrical connection material and the third electrical connection material are melted and then solidified to fixedly connect the pair of conductive connection strips and the first metal wires and the second metal wires between the pair of conductive connection strips together, so as to realize a stable electrical connection between adjacent cell sheets.
4) A bus wire and electrode lead wires are soldered. The one or more cell strings are connected through the bus wire to complete the entire circuit of the module. The electrode lead wires are soldered at wire lead-out positions to connect to an external junction box.
5) A back encapsulant film and a photovoltaic backsheet (which may be back glass) are laid, to form a stack to be laminated.
6) The stack is laminated in a laminating machine, so that the stack is squeezed and bonded into a unity.
7) The junction box and a module frame are installed, and the electrical connection materials are solidified.

While preferred embodiments of the present disclosure have been described above, the present disclosure is not limited thereto. It should be appreciated that some improvements and modifications can be made by those skilled in the art without departing from the technical principles of the present disclosure, which are also contemplated to be within the scope of the present disclosure.

## Claims

1. A photovoltaic cell unit, **characterized by** comprising a cell sheet, a first conductive connection strip, and a second conductive connection strip, wherein the first conductive connection strip and the second conductive connection strip are respectively arranged on two sides of the cell sheet, and the first conductive connection strip is parallel to the second conductive connection strip;
a front surface of the cell sheet is connected to a bottom surface of the first conductive connection strip through a plurality of first metal wires parallel to each other; each of the plurality of first metal wires is fixedly connected to the bottom surface of the first conductive connection strip through an electrical connection material; each of the plurality of first metal wires is further fixedly connected to the front surface of the cell sheet through an electrical connection material; and an end of each of the plurality of first metal wires distant from the first conductive connection strip does not extend to an outer side of the cell sheet;
a back surface of the cell sheet is connected to a top surface of the second conductive connection strip through a plurality of second metal wires parallel to each other; each of the plurality of second metal wires is fixedly connected to the top surface of the second conductive connection strip through an electrical connection material; each of the plurality of second metal wires is further fixedly connected to the back surface of the cell sheet through an electrical connection material;
and an end of each of the plurality of second metal wires distant from the second conductive connection strip does not extend to the outer side of the cell sheet.

2. The photovoltaic cell unit according to claim 1, **characterized in that** the electrical connection material is a conductive adhesive, a conductive paste, or a solder material.

3. The photovoltaic cell unit according to claim 1, **characterized in that** the cell sheet is rectangular; the first conductive connection strip and the second conductive connection strip are parallel to a pair of edge lines of the cell sheet; and each of the plurality of first metal wires and each of the plurality of second metal wires are parallel to a pair of edge lines of the cell sheet.

4. The photovoltaic cell unit according to claim 1, **characterized in that** the first conductive connection strip and the second conductive connection strip are symmetrically arranged.

5. The photovoltaic cell unit according to claim 1, **characterized in that** the plurality of first metal wires are arranged at equal intervals, and a pitch between two adjacent ones of the plurality of first metal wires ranges from 1 mm to 3 mm; and the plurality of second metal wires are arranged at equal intervals, and a pitch between two adjacent ones of the plurality of second metal wires ranges from 1 mm to 3 mm.

6. The photovoltaic cell unit according to claim 1, **characterized in that** the plurality of first metal wires and the plurality of second metal wires each have a line width of 0.05 mm to 0.2 mm.

7. The photovoltaic cell unit according to claim 1, **characterized in that** the plurality of first metal wires and the plurality of second metal wires each have a triangular cross-section, a circular cross-section, a semicircular cross-section, a trapezoidal cross-section, or a rectangular cross-section.

8. The photovoltaic cell unit according to claim 1, **characterized in that** the plurality of first metal wires and the plurality of second metal wires each have a cross-section in a shape of a triangle, and a fillet radius R of a vertex angle of the triangle is 0.03 mm or less, base angles of the triangle are greater than 45°, and a base width of the triangle ranges from 0.05 mm to 0.2 mm.

9. The photovoltaic cell unit according to claim 1, **characterized in that** surfaces of the plurality of first metal wires and the plurality of second metal wires are highly reflective surfaces each with a reflectivity of 80% or more.

10. The photovoltaic cell unit according to claim 1, **characterized in that** a pitch between the first conductive connection strip and the cell sheet and a pitch between the second conductive connection strip and the cell sheet are not greater than 5 mm.

11. The photovoltaic cell unit according to claim 1, **characterized in that** the first conductive connection strip and the second conductive connection strip each have a triangular cross-section, a circular cross-section, a semicircular cross-section, a trapezoidal cross-section, a rectangular cross-section, or a sawtooth-shaped cross-section.

12. The photovoltaic cell unit according to claim 1, **characterized in that** a reflective structure with a reflectivity of 80% or more is provided on the bottom surface of the first conductive connection strip connected to the plurality of first metal wires; and a reflective structure with a reflectivity of 80% or more is provided on the top surface of the second conductive connection strip connected to the plurality of second metal wires.

13. The photovoltaic cell unit according to claim 12, **characterized in that** the reflective structure is a triangular sawtooth structure, and a vertex angle of a tooth of the triangular sawtooth structure ranges from 90° to 140°, and a fillet radius R of the vertex angle is less than or equal to 0.05 mm.

14. The photovoltaic cell unit according to claim 1, **characterized in that** the front surface of the cell sheet is an insulating surface, seed layers are provided on the front surface of the cell sheet and configured to conduct a current, and the plurality of first metal wires are fixedly connected to the seed layers through an electrical connection material, respectively.

15. The photovoltaic cell unit according to claim 1, **characterized in that** the cell sheet has a stacked grid structure; the stacked grid structure comprises ultra-thin seed layers in a form of grid lines provided on surfaces of the cell sheet, and metal wires respectively stacked on the ultra-thin seed layers; the metal wires are respectively parallel to the ultra-thin seed layers on which the metal wires are respectively located, and a width of each of the metal wires is not less than a width of a respective one of the ultra-thin seed layers on which the metal wires are respectively located; and the ultra-thin seed layers comprise: a plurality of first ultra-thin seed layers, wherein the plurality of first ultra-thin seed layers are provided on the front surface of the cell sheet and respectively correspond to the plurality of first metal wires; and a plurality of second ultra-thin seed layers, wherein the plurality of second ultra-thin seed layers are provided on the back surface of the cell sheet and respectively correspond to the plurality of second metal wires.

16. The photovoltaic cell unit according to claim 15, **characterized in that** each of the ultra-thin seed layers has a thickness of less than or equal to 5 µm.

17. The photovoltaic cell unit according to claim 15, **characterized in that** each of the metal wires and the respective one of the ultra-thin seed layers on which the metal wires are respectively located are fixedly connected through a conductive connection material.

18. The photovoltaic cell unit according to claim 15, **characterized in that** each of the metal wires and the respective one of the ultra-thin seed layers on which the metal wires are respectively located are fixedly connected through soldering, a conductive curing adhesive, or a conductive adhesive tape.

19. A method for manufacturing a photovoltaic module by using the photovoltaic cell unit according to any one of claims 1 to 18, comprising the following steps:
1) laying a photovoltaic frontsheet and a front encapsulant film;
2) grabbing photovoltaic cell units and laying the photovoltaic cell units flat on the front encapsulant film according to a module circuit connection structure to form one or more cell strings, wherein in a cell string of the one or more cell strings, the first conductive connection strip of a photovoltaic cell unit of the photovoltaic cell units is stacked on the second conductive connection strip of an adjacent photovoltaic cell unit of the photovoltaic cell units; the plurality of first metal wires on the bottom surface of the first conductive connection strip and the plurality of second metal wires on the top surface of the second conductive connection strip are sandwiched between the first conductive connection strip and the second conductive connection strip; and the first conductive connection strip and the second conductive connection strip stacked together form a pair of conductive connection strips;
3) soldering a bus wire and electrode lead wires;
4) laying a back encapsulant film and a photovoltaic backsheet to form a stack to be laminated;
5) laminating the stack in a laminating machine to bond the stack into a unity, wherein during the laminating, the first electrical connection material and the third electrical connection material between the pair of conductive connection strips are melted to fixedly connect the pair of conductive connection strips and the plurality of first metal wires and the plurality of second metal wires between the pair of conductive connection strips together; and
6) installing a junction box and a module frame.

20. A method for manufacturing a photovoltaic module by using the photovoltaic cell unit according to any one of claims 1 to 18, comprising the following steps:
1) laying a photovoltaic frontsheet and a front encapsulant film;
2) grabbing photovoltaic cell units and laying the photovoltaic cell units flat on the front encapsulant film according to a module circuit connection structure to form one or more cell strings, wherein in a cell string of the one or more cell strings, the first conductive connection strip of a photovoltaic cell unit of the photovoltaic cell units is stacked on the second conductive connection strip of an adjacent photovoltaic cell unit of the photovoltaic cell units; the plurality of first metal wires on the bottom surface of the first conductive connection strip and the plurality of second metal wires on the top surface of the second conductive connection strip are sandwiched between the first conductive connection strip and the second conductive connection strip; and the first conductive connection strip and the second conductive connection strip stacked together form a pair of conductive connection strips;
3) heating the first electrical connection material and the third electrical connection material between the pair of conductive connection strips, so that the first electrical connection material and the third electrical connection material are melted and then solidified to fixedly connect the pair of conductive connection strips and the plurality of first metal wires and the plurality of second metal wires between the pair of conductive connection strips together;
4) soldering a bus wire and electrode lead wires;
5) laying a back encapsulant film and a photovoltaic backsheet to form a stack to be laminated;
6) laminating the stack in a laminating machine to bond the stack into a unity; and
7) installing a junction box and a module frame.
